# FASCICULE DE BREVET EUROPEEN

(11) **EP 0 539 259 B1**
(45) Date de publication et mention de la délivrance du brevet: **20.11.1996**
(21) Numéro de dépôt: 92402761.8
(22) Date de dépôt: 09.10.1992
(51) Int. Cl.: H03M 1/18, H03M 1/16

(54) **Procédé d'acquisition numérique d'un signal électrique analogique cardiaque, et dispositif correspondant**
Verfahren und Vorrichtung zur Erfassung eines analogen elektrokardiographischen Signals
Method and device for digital acquisition of an analogue electrocardiographic signal

(30) Priorité: 25.10.1991 FR 9113178
(43) Date de publication de la demande: 28.04.1993
(73) Titulaire: ELA MEDICAL (Société anonyme), F-92541 Montrouge Cédex (FR)
(72) Inventeur: Faisandier, Yves, F-75014 Paris (FR)
(74) Mandataire: Laget, Jean-Loup

(56) Documents cités:
- EP-A- 0 072 144
- US-A- 3 516 085
- US-A- 4 251 802

## Description

L'invention concerne un procédé d'acquisition numérique d'un signal électrique analogique cardiaque et le dispositif correspondant.

Les signaux électrocardiographiques (ECG) sont des signaux analogiques alternatifs, dont la fréquence est usuellement comprise entre 0,5 et 100Hz, et dont l'amplitude est faible, et d'environ ±5mV lorsqu'ils sont captés à la surface du corps. Ils peuvent atteindre plusieurs dizaines de mV en endocavitaire. Ces signaux sont souvent parasités par les tensions créées par les couples peau-électrodes de recueil, qui peuvent atteindre plusieurs centaines de mV.

Les dispositifs usuels, à microprocesseur et mémoire, pour le recueil des signaux ECG utilisent généralement un amplificateur différentiel suivi d'un filtre passe-haut qui ne laisse passer que les fréquences correspondant aux signaux ECG.

Une difficulté provient du fait que le filtre doit déformer le moins possible les signaux ECG. Or un filtre analogique crée en général un écart de phase important au voisinage de sa fréquence de coupure.

Si la fréquence de coupure est choisie proche de 0,5Hz, le filtre élimine bien les parasites mais il déforme les signaux ECG. Si la fréquence de coupure est choisie plus basse, par exemple proche de 0,05Hz, le filtre ne déforme pas les signaux ECG mais laisse passer des fréquences très basses qui peuvent perturber l'acquisition des signaux ECG.

Pour éviter ces difficultés, un filtre numérique peut être associé à un convertisseur analogique-numérique (A/D). Compte tenu de la gamme des amplitudes des signaux analogiques (±300mV environ) et d'un pas maximum de 10µv, ce convertisseur A/D doit avoir une très grande dynamique, correspondant à 16bits au minimum : il est donc fort coûteux et difficile à mettre en oeuvre.

Lorsque leur amplitude augmente, les signaux ECG peuvent être maintenus, en les modifiant, dans une gamme de tension désirée. On utilise pour cela un système dynamique analogique de retour au 0 : lorsque le signal ECG s'écarte nettement du 0, le système raccourcit automatiquement sa constante de temps afin de replacer le signal dans la gamme de tensions désirée. Le signal ECG reste ainsi visible sur l'écran de surveillance, mais il est déformé. De plus, la mise en oeuvre de circuits à constante de temps variable impose de nombreux composants analogiques et elle est onéreuse.

Il est également connu, cF. le brevet américain US-A-3 516 085, d'étendre la plage d'entrée d'un convertisseur A/D en imposant en décalage à la tension analogique d'entrée. Pour ce faire, un additionneur conventionnel à amplificateur opérationnel est utilisé.

Un but de l'invention est de proposer un procédé d'acquisition du signal ECG qui permette, au moyen d'un convertisseur A/D usuel à 10 bits, d'acquérir un signal ECG quelle que soit son amplitude à l'entrée dans une gamme d'amplitudes de ±300mv.

Un autre but de l'invention est de proposer un dispositif pour la mise en oeuvre de ce procédé, qui fasse appel à des circuits simples à réaliser et donc peu onéreux et peu encombrants.

L'invention a pour objet un dispositif d'acquisition numérique d'un signal analogique cardiaque, du type comprenant un convertisseur analogique-numérique et un microprocesseur, tel que défini dans la revendication 1. Il comporte :
- une capacité d'intégration susceptible d'appliquer au signal cardiaque un décalage de tension,
- un générateur de charges électriques commandé par le microprocesseur, et susceptible de transférer à ladite capacité d'intégration des charges électriques pour provoquer ledit décalage de tension.

Selon l'invention :
- la capacité d'intégration est branchée à l'entrée d'un amplificateur différentiel dont l'autre entrée reçoit le signal analogique cardiaque et dont la sortie est reliée au convertisseur ;
- le générateur de charges électriques comporte un générateur de tension carrée calibrée, une capacité et deux commutateurs, ladite capacité étant branchée entre d'une part le générateur de tension et d'autre part le point commun aux deux commutateurs dont l'un est relié à la masse et l'autre à la capacité d'intégration :
- la capacité d'intégration est montée en boucle de réaction sur un amplificateur différentiel dont l'autre entrée est à la masse ;
- plusieurs voies de transmission de signaux cardiaques sont multiplexées de façon à n'utiliser qu'un convertisseur, un microprocesseur, un générateur de tension et une capacité ;
- le signal analogique cardiaque est appliqué, entre les deux entrées d'un amplificateur différentiel qui reçoit également sur une entrée positive secondaire le décalage de tension en provenance de la capacité d'intégration ;
- la capacité d'intégration est montée en boucle de réaction sur un amplificateur différentiel ;
- les électrodes de recueil du signal électrique analogique cardiaque sont reliées d'une part chacune à une entrée de l'amplificateur différentiel d'entrée, d'autre part l'une à l'autre par un interrupteur susceptible d'annuler les signaux d'entrée pendant la phase d'initialisation du dispositif.

L'invention a également pour objet un procédé d'acquisition numérique d'un signal électrique analogique cardiaque, mettant en oeuvre un convertisseur analogique-numérique, et un microprocesseur, dans lequel : on définit deux valeurs de seuil proches des limites maximale et minimale respectivement, de l'amplitude admissible par le convertisseur ; la valeur numérique du signal ECG établie par le convertisseur est lue par le microprocesseur ; lorsque cette valeur numérique atteint l'une des valeurs de seuil le microprocesseur commande un décalage de la tension analogique à l'entrée du convertisseur de façon à éloigner la valeur numérique établie par le convertisseur de ladite valeur de seuil ; caractérisé en ce que le décalage de la tension analogique d'entrée du convertisseur est réalisé par transfert de charges électriques.

Selon une caractéristique de l'invention, le microprocesseur ajoute, ou retranche, à la valeur numérique fournie par le convertisseur, la valeur numérique correspondant au décalage positif, ou négatif, de tension, de façon à restituer le signal original.

D'autres caractéristiques ressortent de la description suivante d'un mode particulier de réalisation de l'invention, faite avec référence aux dessins annexés sur lesquels on peut voir :
Fig. 1 : un schéma de principe du dispositif d'acquisition de signaux ECG, selon l'invention ;
Fig. 2 : un schéma représentatif de différents signaux électriques utilisés dans le dispositif de la Fig. 1;
Fig. 3 : un schéma d'un mode particulier de réalisation d'un générateur de charges électriques utilisable dans le dispositif de la Fig. 1 ;
Fig. 4 : un schéma représentatif des différentes commandes du générateur de charges de la figure 3.
Fig. 5 ; un schéma à plusieurs voies d'acquisition fonctionnant en multiplex.
Fig. 6 : un schéma d'une variante de réalisation du circuit d'entrée du dispositif de l'invention, assurant les fonctions de circuit différentiel d'entrée et d'intégrateur.

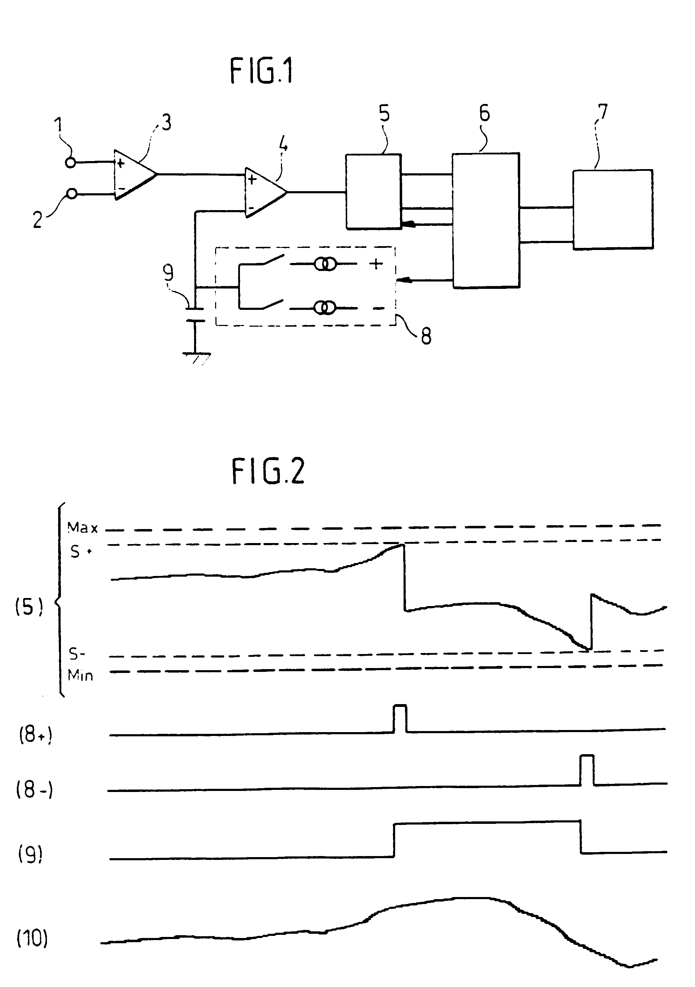

Sur la figure 1 on peut voir les électrodes 1 et 2 de recueil du signal ECG reliées aux entrées d'un premier amplificateur différentiel 3, dont la sortie est reliée à une entrée d'un deuxième amplificateur différentiel 4 de réjection du continu. La sortie de l'amplificateur différentiel 4 est reliée à un convertisseur 5 analogique-numérique (A/D), lui-même relié à un microprocesseur 6 de contrôle, qui alimente une mémoire 7 de stockage des données numériques acquises, et qui commande un circuit 8 générateur de charges électriques positives ou négatives. Une capacité d'intégration 9 est montée entre d'une part la masse, et d'autre part la deuxième entrée de l'amplificateur différentiel 4 de réjection du continu et la sortie du circuit 8 générateur de charges électriques.

Les signaux ECG recueillis par les électrodes 1 et 2 sont débarrassés des tensions de mode commun par l'amplificateur différentiel 3. La capacité d'intégration 9 n'étant traversée, au repos, par aucun courant, la tension à ses bornes est fixe et très stable, positive ou négative. Cette tension est appliquée à l'entrée de l'amplificateur différentiel 4, et elle est soustraite du signal ECG en provenance de l'amplificateur différentiel 3. Le signal résultant est appliqué au convertisseur A/D, 5. Les gains des amplificateurs 3 et 4 sont choisis de façon que le pas du convertisseur A/D, 5, corresponde à 10µV en entrée. Le convertisseur 5 étant de type classique à 10 bits, la dynamique à l'entrée du circuit est de l'ordre de 10 mV (10µV x 1024 # 10mV).

La tension de la capacité d'intégration 9 peut être modifiée par addition de charges positives ou négatives au moyen du circuit générateur de charges 8, sur commande du microprocesseur 6.

Sur la figure 2, l'ensemble de lignes (5) représente le signal à l'entrée du convertisseur A/D 5, avec les limites maximale (Max) et minimale (Min) de l'amplitude admissible par le convertisseur 5, et les seuils de détection positif (S+) et négatif (S-).

La ligne (8+) correspond à la commande de transfert de charges positives par le circuit générateur de charges. La ligne (8-) correspond à la commande de transfert de charges négatives. La ligne (9) représente la tension de la capacité d'intégration 9 avec deux décalages de tension, l'un positif, l'autre négatif. La ligne (10) correspond à la valeur numérique du signal ECG, après calcul par le microprocesseur.

Le fonctionnement du dispositif de la Fig. 1 s'analyse de la manière suivantes :

A la mise en route du dispositif, pendant la phase d'initialisation, on mesure la valeur numérique du décalage de tension produit par un transfert de charges, en l'absence de signal ECG à l'entrée.

Ce décalage de tension, ou incrément, peut avoir une valeur différente, suivant qu'il est positif ou négatif, pour des raisons de non-équilibre des circuits : le microprocesseur enregistre alors deux valeurs distinctes.

Le générateur 8 de charges électriques est très stable, et prévu pour transférer toujours la même quantité de charges (positives ou négatives) à la capacité d'intégration 9. Le transfert de charges étant parfaitement reproductible, le décalage de tension qu'il produit sur la capacité 9 est également reproductible.

Le convertisseur A/D 5 fournit au microprocesseur 6 la valeur numérique du décalage de tension induit par un transfert de charges. Cette valeur numérique est stockée dans la mémoire 7 en vue des calculs ultérieurs.

Au cours de la phase de fonctionnement normal du dispositif, le microprocesseur 6 lit les valeurs numériques qui lui sont transmises par le convertisseur A/D 5. Si la valeur du signal ECG atteint l'une des valeurs de seuil (S+, ou S-), le microprocesseur 6 commande au générateur de charges électriques 8 de procéder à un transfert de charges (positives (8+), ou négatives (8-), respectivement). Ce transfert de charges se traduit, à l'entrée du convertisseur A/D 5 par un décalage de la tension vers la zone centrale de la gamme des tensions admissibles et le convertisseur A/D 5 délivre au microprocesseur 6 une valeur numérique éloignée de la valeur de seuil atteinte.

Pour tenir compte du décalage intervenu à l'entrée du convertisseur A/D 5, le microprocesseur ajoute, ou retranche, à la valeur numérique fournie par le convertisseur A/D 5, la valeur numérique mémorisée correspondant à ce décalage.

Le microprocesseur met en mémoire une valeur numérique exacte du signal ECG, représentée, à la ligne (10) sur la figure 2. Le résultat numérique correspond ainsi au signal original même si celui-ci s'écarte jusqu'à 30 fois, en plus ou en moins, de la dynamique du convertisseur A/D 5. On peut ainsi enregistrer un signal ECG sous forme numérique, avec un convertisseur A/D à 10 bits, quelles que soient les variations de tension à l'entrée dans la gamme de ± 300mV, avec un signal non déformé, c'est-à-dire équivalent à celui que fournirait un convertisseur à 19 bits.

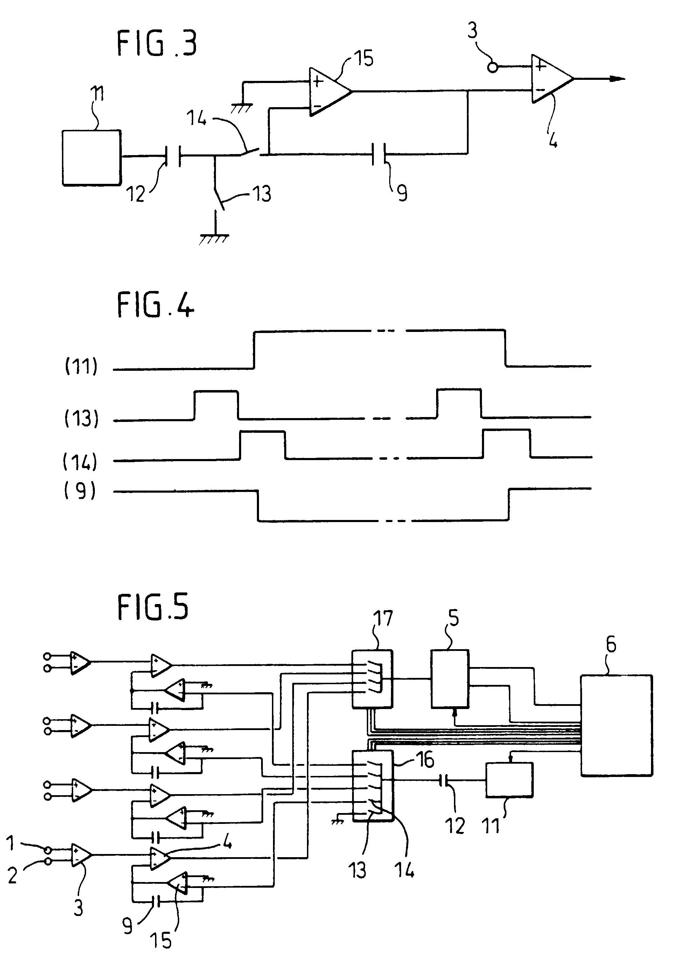

Sur la figure 3, le générateur de charges électriques comporte essentiellement un générateur 11 de tension carrée (0,+5V) calibrée, une capacité 12 et deux commutateurs 13,14. Le générateur 11 commande une borne de la capacité 12 dont l'autre borne est reliée d'une part à la masse par le commutateur 13, d'autre part à la capacité 9 par le commutateur 14. La capacité d'intégration 9 est montée en boucle de réaction sur un amplificateur différentiel 15 dont une entrée est à la masse, l'ensemble constituant un intégrateur. Les autres éléments du circuit de la Figure 1 sont conservés.

La figure 4 représente les signaux de commande appliqués aux différents éléments du circuit de la figure 3, chaque ligne portant la référence de l'élément correspondant.

Au repos, le commutateur 14 est ouvert. Pour transférer une charge positive, (partie gauche de la Fig. 4), le microprocesseur 6 met le générateur de tension 11 à 0, puis il ferme le commutateur 13 de façon à décharger la capacité 12. il ouvre ensuite le commutateur 13, puis il ferme le commutateur 14, puis il met le générateur 11 à 5V. Enfin, le commutateur 14 est de nouveau ouvert. Les charges de la capacité 12 sont alors transférées à la capacité d'intégration 9.Le décalage négatif en tension qui en résulte en sortie de la capacité d'intégration 9 est proportionnel au décalage positif en tension fourni par le générateur 11, et proportionnel au rapport de la capacité 12 à la capacité 9.

Le transfert d'une charge négative s'effectue en répétant les mêmes opérations, en partant d'une tension du générateur 11 de +5V et en l'abaissant à 0, selon la partie droite de la Fig. 4.

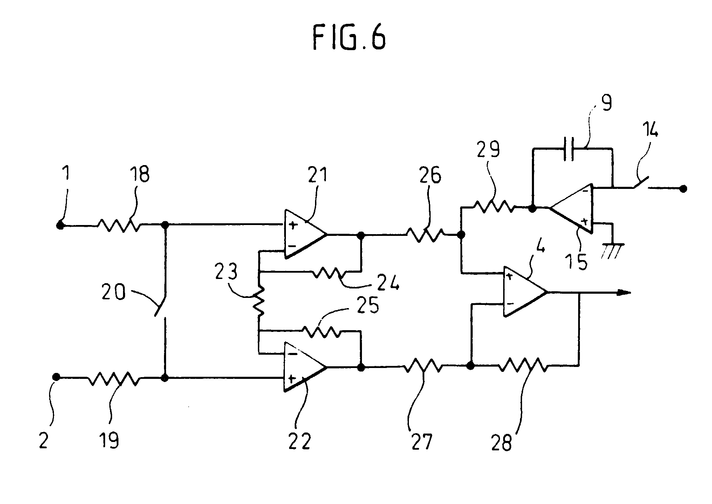

La figure 5 correspond à l'extension à plusieurs voies d'acquisition de signaux ECG. Dans cet exemple, quatre voies sont représentées, comportant chacune quelques éléments individuels : électrodes 1 et 2, amplificateurs différentiels 3, 4 et 15, et capacité 9. Les autres éléments sont communs : convertisseur A/D 5, microprocesseur 6, générateur de tension 11, capacité 12, commutateur 13. Un multiplexeur 16, 17 contrôle les commutateurs 14 et la transmission de signaux ECG au convertisseur A/D 5. La valeur numérique du décalage est mesurée à la mise en route, indépendamment pour chaque voie.

Dans la variante de réalisation de la Fig. 6, les électrodes 1, 2 sont réunies par l'intermédiaire de deux résistances 18, 19 à un interrupteur 20 susceptible, lorsqu'il est fermé, d'annuler les signaux d'entrée pendant la phase d'initialisation où l'on mesure les décalages de tension produits par l'intégrateur constitué par l'amplificateur différentiel 15 et la capacité 9 montée en boucle de réaction.

Chaque borne d'entrée 1, 2 attaque l'entrée positive d'un amplificateur différentiel 21, 22, respectivement. Les entrées négatives de ces amplificateurs différentiels 21, 22, sont reliées par l'intermédiaire d'une résistance 23. En outre, sur chacun des deux amplificateurs différentiels 21, 22 est montée une résistance 24, 25, respectivement, en boucle de réaction sur l'entrée négative. Les sorties des amplificateurs différentiels 21, 22 sont reliées, par l'intermédiaire des résistances 26, 27 respectivement, aux deux entrées, positive et négative, respectivement, d'un amplificateur différentiel 4. Une résistance 28 est montée entre la sortie de l'amplificateur différentiel 4 et son entrée négative. Une résistance 29 relie l'entrée positive de l'amplificateur différentiel 4 à la sorite de l'amplificateur différentiel 15 dont l'entrée positive est à la masse. Entre l'entrée négative de l'amplificateur différentiel 15 et sa sortie, est montée la capacité d'intégration 9. L'entrée négative de l'amplificateur différentiel 15 est alimentée comme dans le cas de la Fig. 3, par l'intermédiaire de l'interrupteur 14.

Le amplificateurs 21 et 22 associés aux résistances 23, 24, 25, réalisent une amplification différentielle, le mode commun restant au même niveau qu'à l'entrée. L'amplificateur différentiel 4 élimine le mode commun.

Les amplificateurs 21, 22 et 4 fonctionnent en différentiel d'entrée.

L'amplificateur 15 et la capacité 9 assurent la fonction d'intégration et attaquent l'entrée positive de l'amplificateur différentiel 4.

## Revendications

1. Dispositif d'acquisition numérique d'un signal analogique cardiaque, du type comprenant un convertisseur analogique-numérique (A/D) (5) et un microprocesseur (6) susceptible de lire la valeur numérique du signal ECG établie par le convertisseur A/D (5) et de commander un décalage de la tension analogique à l'entrée du convertisseur A/D (5) de façon à éloigner la valeur numérique établie par le convertisseur d'une valeur de seuil (S+, S-), caractérisé en ce qu'il comporte :
- une capacité d'intégration (9) susceptible d'appliquer au signal cardiaque un décalage de tension,
- un générateur de charges électriques (8) commandé par le microprocesseur, et susceptible de transférer à ladite capacité d'intégration (9) des charges électriques pour provoquer ledit décalage de tension.

2. Dispositif selon la revendication 1, caractérisé en ce que la capacité d'intégration (9) est branchée à l'entrée d'un amplificateur différentiel (4) dont l'autre entrée reçoit le signal analogique cardiaque et dont la sortie est reliée au convertisseur A/D (5).

3. Dispositif selon la revendication 1, caractérisé en ce que le générateur (8) de charges électriques comporte un générateur (11) de tension carrée calibrée, une capacité (12) et deux commutateurs (13, 14), ladite capacité (12) étant branchée entre d'une part le générateur de tension (11) et d'autre part le point commun aux deux commutateurs (13, 14) dont l'un (13) est relié à la masse et l'autre (14) à la capacité d'intégration (9).

4. Dispositif selon la revendication 3, caractérisé en ce que la capacité d'intégration (9) est montée en boucle de réaction sur un amplificateur différentiel (15) dont l'autre entrée est à la masse.

5. Dispositif selon la revendication 3, caractérisé en ce que plusieurs voies de transmission de signaux cardiaques sont multiplexées de façon à n'utiliser qu'un convertisseur A/D (5), un microprocesseur (6), un générateur de tension (11) et une capacité (12).

6. Dispositif selon la revendication 1, caractérisé en ce que le signal analogique cardiaque est appliqué, entre les deux entrées d'un amplificateur différentiel (4) qui reçoit également sur une entrée positive secondaire le décalage de tension en provenance de la capacité d'intégration (9).

7. Dispositif selon la revendication 6, caractérisé en ce que la capacité d'intégration (9) est montée en boucle de réaction sur un amplificateur différentiel (15).

8. Dispositif selon la revendication 6, caractérisé en ce que les électrodes (1, 2) de recueil du signal électrique analogique cardiaque sont reliées d'une part chacune à une entrée de l'amplificateur différentiel d'entrée (21, 22), d'autre part l'une à l'autre par un interrupteur (20) susceptible d'annuler les signaux d'entrée pendant la phase d'initialisation du dispositif.

9. Procédé d'acquisition numérique d'un signal électrique analogique cardiaque, mettant en oeuvre un convertisseur analogique-numérique (A/D), et un microprocesseur, dans lequel : on définit deux valeurs de seuil (S+, S-) proches des limites maximale et minimale respectivement, de l'amplitude admissible par le convertisseur A/D (5) ; la valeur numérique du signal ECG établie par le convertisseur A/D (5) est lue par le microprocesseur (6) ; lorsque cette valeur numérique atteint l'une des valeurs de seuil (S+, S) le microprocesseur (6) commande un décalage de la tension analogique à l'entrée du convertisseur A/D (5) de façon à éloigner la valeur numérique établie par le convertisseur de ladite valeur de seuil ; caractérisé en ce que le décalage de la tension analogique d'entrée du convertisseur est réalisé par transfert de charges électriques.

10. Procédé selon la revendication 9, caractérisé en ce que le microprocesseur (6) ajoute, ou retranche, à la valeur numérique fournie par le convertisseur A/D (5), la valeur numérique correspondant au décalage positif, ou négatif, de tension, de façon à restituer le signal original.

## Patentansprüche

1. Vorrichtung zur digitalen Erfassung eines analogen Herz-Signals, mit einem Analog-Digital-Wandler (A/D) (5) und einem Mikroprozessor, der den digitalen Wert des durch den Analog-Digital-Wandler A/D (5) erfaßten EKG-Signals lesen und eine Verschiebung der analogen Spannung am Eingang des Analog-Digital-Wandlers A/D (5) so steuern kann, daß der durch den Wandler erfaßte digitale Wert von einem Schwellenwert (S+, S-) entfernt wird,
**gekennzeichnet durch:**
- einen integrierenden Kondensator (9), der eine Spannungsverschiebung des Herz-Signals bewirken kann, und
- eine durch den Mikroprozessor gesteuerte Erzeugungseinrichtung für elektrische Ladungen (8), die elektrische Ladungen zum integrierenden Kondensator (9) übertragen kann, um die Spannungsverschiebung zu bewirken.

2. Vorrichtung nach Anspruch 1,
**dadurch gekennzeichnet, daß**
der integrierende Kondensator (9) an den Eingang eines Differenzverstärkers (4) angeschlossen ist, dessen anderer Eingang das analoge Herz-Signal empfängt und dessen Ausgang an den Analog-Digital-Wandler (5) angeschlossen ist.

3. Vorrichtung nach Anspruch 1,
**dadurch gekennzeichnet, daß**
die Erzeugungseinrichtung (8) elektrischer Ladungen einen kalibrierten Rechteckspannungs-Generator (11), einen Kondensator (12) und zwei Umschalter (13, 14) umfaßt, wobei der Kondensator (12) zwischen dem Spannungs-Generator (11) und dem gemeinsamen Knoten der zwei Umschalter (13, 14) angeschlossen ist, von denen einer (13) mit Masse und der andere (14) mit dem integrierenden Kondensator (9) verbunden ist.

4. Vorrichtung nach Anspruch 3,
**dadurch gekennzeichnet, daß**
der integrierende Kondensator (9) als Rückkopplungszweig eines Differenzverstärkers (15) verschaltet ist, dessen anderer Eingang auf Masse liegt.

5. Vorrichtung nach Anspruch 3,
**dadurch gekennzeichnet, daß**
eine Vielzahl von Übertragungskanälen für die Herz-Signale so gemultiplext sind, daß sie nur einen Analog-Digital-Wandler A/D (5), einen Mikroprozessor (6), einen Spannungs-generator (11) und einen Kondensator (12) nutzen.

6. Vorrichtung nach Anspruch 1,
**dadurch gekennzeichnet, daß**
das analoge Herz-Signal zwischen den zwei Eingängen eines Differenzverstärkers (4) anliegt, der an einem positiven zweiten Eingang auch die von dem integrierenden Kondensator (9) herrührende Spannungsverschiebung empfängt.

7. Vorrichtung nach Anspruch 6,
**dadurch gekennzeichnet, daß**
der integrierende Kondensator (9) als Rückkopplungszweig eines Differenzverstärkers (15) verschaltet ist.

8. Vorrichtung nach Anspruch 6,
**dadurch gekennzeichnet, daß**
die Elektroden (1, 2) zur Erfassung des analogen elektrischen Herz-Signals einerseits jeweils mit einem Eingang des Eingangs-Differenzverstärkers (21, 22) und andererseits miteinander durch einen Unterbrecherschalter (20) verbunden sind, der die Eingangssignale während der Initialisierungsphase der Vorrichtung annullieren kann.

9. Verfahren zur digitalen Erfassung eines analogen elektrischen Herz-Signals, das einen Analog-Digital-Wandler (A/D) und einen Mikroprozessor verwendet, bei dem:
zwei Schwellenwerte (S+, S-) definiert sind, die jeweils nahe den Maximal- und Minimalwerten der zulässigen Amplitude des Analog-Digital-Wandlers A/D (5) liegen;
der digitale Wert des durch den Analog-Digital-Wandler A/D (5) erzeugten EKG-Signals durch den Mikroprozessor (6) gelesen wird;
wenn dieser digitale Wert einen der Schwellenwerte (S+, S-) erreicht, der Mikroprozessor (6) eine analoge Spannungsverschiebung am Eingang des Analog-Digital-Wandlers (5) derart steuert, daß sich der durch den Wandler erzeugte digitale Wert von dem Schwellenwert entfernt;
**dadurch gekennzeichnet, daß**
die Verschiebung der analogen Eingangsspannung des Wandlers durch Übertragung elektrischer Ladungen bewirkt wird.

10. Verfahren nach Anspruch 9,
**dadurch gekennzeichnet, daß**
der Mikroprozessor (6) zu dem von dem Analog-Digital-Wandler A/D (5) erzeugten Wert den der positiven Verschiebung entsprechenden digitalen Wert hinzufügt oder den der negativen entsprechenden von diesem abzieht, so daß das Originalsignal zurückgewonnen wird.

## Claims

1. A device for the digital acquisition of a cardiac analog signal, of the type comprising an analog/digital converter (A/D) (5) and a microprocessor capable of reading the digital value of the ECG signal established by the A/D converter (5) and of controlling a staggering of the analog voltage at the input of the AID converter (5) so as to distance the digital value established by the converter from a threshold value (S+, S-), characterised in that it comprises:
- an integration capacity (9) capable of applying a voltage staggering to the cardiac signal,
- a generator of electrical charges (8) controlled by the microprocessor and capable of transferring to said integration capacity (9) electrical charges to cause said voltage staggering.

2. A device according to Claim 1, characterised in that the integration capacity (9) is connected to the input of a differential amplifier (4), the other input of which receives the cardiac analog signal and the output of which is connected to the A/D converter (5).

3. A device according to Claim 1, characterised in that the generator (8) of electrical charges comprises a generator (11) of calibrated square wave voltage, a capacity (12) and two switches (13, 14), said capacity (12) being connected between on the one hand the voltage generator (11) and on the other hand the point common to the two switches (13, 14), one (13) of which is connected to earth and the other (14) of which is connected to the integration capacity (9).

4. A device according to Claim 3, characterised in that the integration capacity (9) is mounted in a reaction loop on a differential amplifier (15), the other input of which is earthed.

5. A device according to Claim 3, characterised in that several paths for transmission of cardiac signals are multiplexed so as to use only one A/D converter (5), one microprocessor (6), one voltage generator (11) and one capacity (12).

6. A device according to Claim 1, characterised in that the cardiac analog signal is applied between the two inputs of a differential amplifier (4) which likewise receives at a positive secondary input the voltage staggering originating from the integration capacity (9).

7. A device according to Claim 6, characterised in that the integration capacity (9) is mounted in a reaction loop on a differential amplifier (15).

8. A device according to Claim 6, characterised in that the electrodes (1, 2) for collection of the cardiac analog electrical signal are connected on the one hand each to an input of the differential input amplifier (21, 22) and on the other hand one to the other by a switch (20) capable of cancelling the input signals during the initialisation phase of the device.

9. A process for the digital acquisition of a cardiac analog electrical signal, using an analog/digital converter (A/D), and a microprocessor, in which: two threshold values (S+, S-) are defined, close to the maximum and minimum limits respectively of the amplitude permissible by the A/D converter (5); the digital value of the ECG signal established by the A/D converter (5) is read by the microprocessor (6); when this digital value reaches one of the threshold values (S+, S-), the microprocessor (6) controls a staggering of the analog voltage at the input of the A/D converter (5) so as to distance the digital value established by the converter from said threshold value; characterised in that the staggering of the analog input voltage of the converter is realised by transfer of electrical charges.

10. A method according to Claim 9, characterised in that the microprocessor (6) adds to or cuts from the digital value supplied by the A/D converter (5) the digital value corresponding to the positive or negative staggering of voltage, so as to restore the original signal.
